# EUROPEAN PATENT APPLICATION

(11) **EP 1 903 078 A2**
(43) Date of publication of application: **26.03.2008**
(21) Application number: 07012704.8
(22) Date of filing: 28.06.2007
(51) Int. Cl.: C09B 29/00, C09B 29/48, B41M 5/388, G03G 9/09, C09D 11/00, G02B 5/22

(54) **Azo dye, heat-sensitive transfer recording ink sheet, heat-sensitive transfer recording method, color toner, inkjet ink and color filter**

(30) Priority: 29.06.2006 JP 2006180447
(71) Applicant: FUJIFILM Corporation, Minato-ku Tokyo (JP)
(72) Inventor: Fujie, Yoshihiko, Minami-ashigara-shi Kanagawa 250-0193 (JP); Mikoshiba, Hisashi, Minami-ashigara-shi Kanagawa 250-0193 (JP); Amemiya, Takuma, Odawara-shi Kanagawa 250-0001 (JP); Omura, Kazufumi, Odawara-shi Kanagawa 250-0001 (JP); Shinohara, Ryuji, Minami-ashigara-shi Kanagawa 250-0193 (JP)
(74) Representative: HOFFMANN EITLE

(57) **Abstract**

An azo dye represented by formula (1): 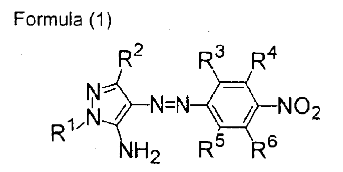 wherein R¹ represents an alkyl group having 1 to 6 carbon atoms; and R² to R⁶ each independently represents a hydrogen atom or a substituents, and an ink sheet for heat-sensitive transfer recording, a heat-sensitive transfer recording method, a color toner, an inkjet ink, and a color filter, each utilizes the azo dye.

## Description

### FIELD OF THE INVENTION

The present invention relates to a particular novel azo dye; and a heat-sensitive transfer recording ink sheet, a heat-sensitive transfer recording method, a color toner, an ink for inkjet, and a color filter, each of which utilizes the azo dye.

### BACKGROUND OF THE INVENTION

In recent years, in particular, materials for forming a color image have been mainly used as an image recording material. Specifically, recording materials of inkjet system, recording materials of heat-sensitive transfer system, recording materials of electrophotographic system, silver halide photosensitive materials of transfer system, printing inks, recording pens, and the like, have been used extensively. Color filters are used in image devices, such as CCD for photographing equipment, and in displays, such as LCD and PDP, to record and reproduce color images.

For these color image recording materials and color filters, colorants (dyes or pigments) of three primary colors are used based on a so-called additive color mixing system or subtractive color mixing system, to reproduce or record full-color images. A colorant, which has absorption characteristics that enable the acquisition of a preferred color reproduction range and has fastness under various conditions for use, is not available yet, and its improvement is strongly desired.

As the heat-sensitive transfer recording method, there are a process including the steps of heating a heat-sensitive transfer material having a base film (support) and a hot-melt ink layer formed thereon with a thermal head, and recording the melted ink to an image-receiving material; and a process including the steps of heating a heat-sensitive transfer material having a base film and a dye-providing layer formed thereon that contains a heat transfer dye with a thermal head, and thermal diffusion transferring of the dye to an image-receiving material. The latter heat-sensitive transfer process is able to change a transfer amount of the dye by altering energy applied to a thermal head, so that a gradation recording is easily achieved. Consequently, such the process is especially advantageous to a high quality full color recording. However, because the heat transfer dye usable in the process is limited for various points, only a considerably few dye satisfies all the performances required for the process.

As the performances required for the process, there are, for example, spectral characteristics preferred in terms of color reproduction, easiness of transfer, fastness to light and heat, resistance to various chemicals, easiness of synthesis of the dye itself and of production of heat-sensitive transfer recording materials.

As the dye having both spectral characteristics preferred in terms of color reproduction and fastness to light and heat, the dyes disclosed in JP-A-1-225592 ("JP-A" means unexamined published Japanese patent application) and JP-A-63-189289 can be mentioned as examples. The transfer sensitivities of these dyes were sufficient for the heat-sensitive transfer recording at the time when such the inventions were disclosed in these publications, but were not sufficient for the current high-speed-transfer type heat-sensitive transfer recording. Accordingly, there is a demand for improvement in transfer sensitivity.

As the dyes that are excellent in transfer sensitivity, the dyes disclosed in JP-A-3-108583, JP-A-63-182193, JP-B-4-47635 ("JP-B" means examined Japanese patent publication) and JP-B-4-22714 can be mentioned as examples. However, as a result of promotion (speeding up) in a transfer speed according to a recent progress in technology, many dyes are not enough to fulfill the requirements for transfer sensitivity. Among these dyes, as the dyes that show excellent transfer sensitivity even in the high-speed-transfer type heat-sensitive transfer recording, the dyes disclosed in JP-A-3-108583 can be mentioned as examples. However, these dyes are not satisfactory in terms of fastness to light and heat. Therefore, compatibility of high speed transferring property and fastness has been strongly desired.

On the other hand, a dye having a high solubility to a solvent enables not only the reduction of a working load for dissolving the dye at the time of preparing a heat-sensitive transfer ink sheet, but also the preparation of a highly concentrated ink sheet solution. Consequently, such the dye is useful because a use amount of organic solvents can be saved, which results in reduction of load to environment. Therefore, it has been desired to develop a heat-sensitive transfer dye having a high solubility to a solvent.

Generally, toners containing a colorant dispersed in resin particles are widely used in color copiers and color laser printers of electrophotographic system. The properties required for the color toners include absorption characteristics that enable the acquisition of a preferred color reproduction range, high transmission (transparency) which becomes a problem in particular, when they are used in an over head projector (OHP); and (color)fastness against various factors under environmental conditions when using. Toners containing a pigment as a colorant dispersed in particles are disclosed in JP-A-62-157051, JP-A-62-255956 and JP-A-6-118715. Although these toners have excellent light resistance, they easily aggregate since they are insoluble in a solvent, thereby causing problems such as decreases in transparency and changes in hue of transmitted color. On the other hand, toners containing a dye as a colorant are disclosed in JP-A-3-276161, JP-A-2-207274 and JP-A-2-207273. These toners have rather high transparency and show no change in hue but have a problem in a light resistance.

Because of inexpensive material costs, capability of high-speed recording, reduced noise in recording operations, and ease in color recording, inkjet recording has rapidly come into wide use and is being further developed.

Inkjet recording methods include a continuous method in which droplets are supplied continuously and an on-demand method in which droplets are supplied in response to an image information signal. Ink discharge systems include: 1) one in which droplets are discharged by applying pressure with a piezoelectric element, 2) one in which droplets are discharged by producing air bubbles in ink with heat, 3) one using ultrasonic waves, and 4) one in which droplets are discharged by electrostatic suction. Aqueous ink, oil-based ink, and solid (melting) ink are used as inkjet-recording ink.

The properties required for a colorant that is used in the inkjet-recording ink are: good solubility or dispersibility in a solvent; capability of high-density recording; good hue; fastness to light, heat, an active gas in environment (e.g. oxidative gases such as ozone, NOx, as well as SOx); excellent fastness to water and chemicals; good fixation and little blur on image-receiving materials; excellent storability as ink; being free from toxicity; high purity; and being available inexpensively. However, it is very difficult to provide a colorant that satisfies these requirements on a high level. Particularly, it is desired that a colorant should have a good yellow hue, high solubility, and fastness to light, humidity and heat, and in particular, fastness to light is strongly desired.

Since a color filter needs to have high transparency, a method called a dyeing method, in which the color filter is colored with a dyestuff, has been carried out. For instance, a photoresist which can be dyed is subjected to pattern exposure and development to form a pattern, and then the resulting pattern is dyed with a filter color dyestuff. Subsequently, these steps are repeated for all the colors of the filter, to produce a color filter. Besides the above dyeing method; a color filter can also be produced by a method using a positive-type resist. These methods provide a color filter which has high transmittance and is excellent in optical characteristics by use of a dyestuff, but they have limitations to properties such as light resistance and heat resistance. Therefore, a dye which is excellent in resistances to various factors and in transparency has been desired. Meanwhile, a method of using an organic pigment as a dye having excellent light resistance and heat resistance in place of the dyestuff is widely known, but a color filter employing such a pigment hardly gives desired optical properties equivalent to those employing a dyestuff.

Dyes for use in the above various applications must have the following properties in common. That is, they must have, for example, a hue preferred from the viewpoint of color reproduction, an optimum spectral absorption, excellent fastness-properties such as fastness to light, humidity resistance and chemical resistance, and a high solubility.

On the other hand, azo dyes having an azo bond at the 4-position of a pyrazole,ring are disclosed in JP-A-2005-226022, JP-A-2003-221535, JP-A-2003-128953, JP-A-8-90939, JP-A-6-106862, and JP-A-2-24191. However, these publications are silent in that the dyes represented by formula (1) set forth below can be effectively used for a heat-sensitive transfer recording, a color toner, an inkjet ink, and a color filter, and especially for a heat-sensitive transfer recording.

### SUMMARY OF THE INVENTION

The present invention resides in an azo dye represented by formula (1): 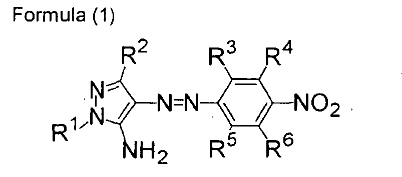 wherein R¹ represents an alkyl group having 1 to 6 carbon atoms; and R², R³, R⁴, R⁵, and R⁶ each independently represents a hydrogen atom or a substituent.

The present invention also resides in an ink sheet for heat-sensitive transfer recording, a heat-sensitive transfer recording method, a color toner, an inkjet ink, and a color filter, each using the aforementioned azo dye.

Other and further features and advantages of the invention will appear more fully from the following description, appropriately referring to the accompanying drawings.

### BRIEF DESCRIPTION OF THE DRAWINGS

Fig. 1 shows a reflection spectrum of the image obtained by inkjet recording in a working example.
Fig. 2 shows a transmission spectrum of the color filter prepared in a working example.

### DETAILED DESCRIPTION OF THE INVENTION

According to the present invention, there is provided the following means:
(1) An azo dye represented by formula (1): 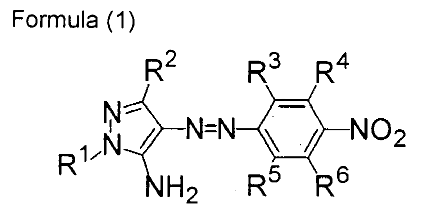 wherein R¹ represents an alkyl group having 1 to 6 carbon atoms; and R², R³, R⁴, R⁵, and R⁶ each independently represents a hydrogen atom or a substituent.
(2) A heat-sensitive transfer recording ink sheet comprising the azo dye as described in the item (1).
(3) A heat-sensitive transfer recording method, comprising the step of: forming an image with using the heat-sensitive transfer recording ink sheet as described in the item (2), on an image-receiving material having, on a support (base), an ink-receiving layer containing a polymer.
(4) A color toner comprising the azo dye as described in the item (1).
(5) An ink for inkjet comprising the azo dye as described in the item (1).
(6) A color filter comprising the azo dye as described in the item (1).

Hereinafter, the azo dye, and the heat-sensitive transfer recording ink sheet, the heat-sensitive transfer recording method, the color toner, the inkjet ink, and the color filter, each of which uses the azo dye, of the present invention will be explained in detail. The constitutional requirements described below may be embodied on the basis of the representative embodiments of the present invention. However the present invention is not limited to such embodiments.

In the present specification, "to" denotes a range including numerical values described before and after it as a minimum value and a maximum value.

First, there are explained in detail the azo dye represented by the above-described formula (1) of the present invention.

The 5-aminopyrazolyl azo dye represented by the above-described formula (1) is characterized in that R¹ is an alkyl group having 1 to 6 carbon atoms. This dye has a smaller molecular weight and more excellent solubility, compared with 5-aminopyrazolyl azo dyes in which R¹ is an aryl group or a heteroaryl group. Therefore, the 5-aminopyrazolyl azo dye of the present invention is favorably used in a heat-sensitive transfer recording ink sheet and also other uses (for example, an ink solution).

In formula (1), R¹ represents an alkyl group having 1 to 6 carbon atoms. Specific examples include a methyl group, an ethyl group, a n-propyl group, an isopropyl group, a n-butyl group, an isobutyl group, a s-butyl group, a n-pentyl group, a neopentyl group, and a n-hexyl group.

In formula (1), R², R³, R⁴, R⁵ and R⁶ each independently represents a hydrogen atom or a substituent. There is no particular limitation on the substituent. Representative examples of the substituent include a halogen atom, an alkyl group (the term "alkyl group" used in this specification means a saturated aliphatic group including a cycloalkyl group and a bicycloalkyl group), an alkenyl group (the term "alkenyl group" used in this specification means an unsaturated aliphatic group having a double bond, that includes a cycloalkenyl group and a bicycloalkenyl group), an alkynyl group, an aryl group, a heterocyclic group, a cyano group, an alkoxy group, an aryloxy group, an acyloxy group, a carbamoyloxy group, an alkoxycarbonyloxy group, an aryloxycarbonyloxy group, an amino group (including an alkylamino group, an anilino group, and a heterocyclic amino group), an acylamino group, an aminocarbonylamino group, an alkoxycarbonylamino group, an aryloxycarbonylamino group, a sulfamoylamino group, an alkyl- or aryl-sulfonylamino group, an alkylthio group, a sulfamoyl group, an alkyl- or aryl-sulfinyl group, an alkyl- or aryl-sulfonyl group, an acyl group, an aryloxycarbonyl group, an alkoxycarbonyl group, a carbamoyl group, an aryl- or heterocyclic-azo group, or an imido group. Each of these may further have a substituent(s).

Hereinafter, R², R³, R⁴, R⁵ and R⁶will be explained in more detail.

The halogen atom represented by R², R³, R⁴, R⁵ and R⁶ includes a fluorine atom, a chlorine atom, a bromine atom, and an iodine atom. Of these, a chlorine atom and a bromine atom are preferable, a chlorine atom is particularly preferable.

The alkyl group represented by R², R³, R⁴, R⁵ and R⁶ includes a cycloalkyl group and a bicycloalkyl group. The alkyl group includes a substituted or unsubstituted, linear or branched alkyl group. The substituted or unsubstituted, linear or branched alkyl group is preferably an alkyl group having 1 to 30 carbon atoms. Examples of the alkyl group include a methyl group, an ethyl group, an n-propyl group, an isopropyl group, a t-butyl group, an n-octyl group, an eicosyl group, a 2-chloroethyl group, a 2-cyanoethyl group, or a 2-ethylhexyl group. The cycloalkyl group includes a substituted or unsubstituted cycloalkyl group. The substituted or unsubstituted cycloalkyl group is preferably a cycloalkyl group having 3 to 30 carbon atoms. Examples of the cycloalkyl group include a cyclohexyl group, a cyclopentyl group and a 4-n-dodecylcyclohexyl group. The bicycloalkyl group includes a substituted or unsubstituted bicycloalkyl group having 5 to 30 carbon atoms, i.e. a monovalent group obtained by removing one hydrogen atom from a bicycloalkane having 5 to 30 carbon atoms. Examples of the bicycloalkyl group include a bicyclo[1,2,2]heptan-2-yl group or a bicyclo[2,2,2]octan-3-yl group, and a tricyclo or higher structure having three or more ring structures. An "alkyl" group in a substituent described below (e.g. an "alkyl" group in an alkylthio group) represents such an "alkyl" group of the above concept.

The alkenyl group represented by R², R³, R⁴, R⁵ and R⁶ includes a cycloalkenyl group and a bicycloalkenyl group. The alkenyl group represents a substituted or unsubstituted, linear, branched, or cyclic alkenyl group. The alkenyl group is preferably a substituted or unsubstituted alkenyl group having 2 to 30 carbon atoms. Examples of the alkenyl group include a vinyl group, an allyl group, a prenyl group, a geranyl group, or an oleyl group. The cycloalkenyl group is preferably a substituted or unsubstituted cycloalkenyl group having 3 to 30 carbon atoms, i.e. a monovalent group obtained by removing one hydrogen atom from a cycloalkene having 3 to 30 carbon atoms. Examples of the cycloalkenyl group include a 2-cyclopenten-1-yl group or a 2-cyclohexen-1-yl group. The bicycloalkenyl group includes a substituted or unsubstituted bicycloalkenyl group, and preferably a substituted or unsubstituted bicycloalkenyl group having 5 to 30 carbon atoms, i.e. a monovalent group obtained by removing one hydrogen atom from a bicycloalkene having one double bond. Examples of the bicycloalkenyl group include a bicyclo[2,2,1]hept-2-en-I-yl group or a bicyclo[2,2,2]oct-2-en-4-yl group.

The alkynyl group represented by R², R³, R⁴, R⁵ and R⁶ is preferably a substituted or unsubstituted alkynyl group having 2 to 30 carbon atoms, e.g. an ethynyl group, or a propargyl group.

The aryl group represented by R², R³, R⁴, R⁵ and R⁶ is preferably a substituted or unsubstituted aryl group having 6 to 30 carbon atoms, e.g. a phenyl group, a p-tolyl group, a naphthyl group, an m-chlorophenyl group, or an o-hexadecanoylaminophenyl group.

The heterocyclic group represented by R², R³, R⁴, R⁵ and R⁶ is a monovalent group obtained by removing one hydrogen atom from a substituted or unsubstituted, aromatic or nonaromatic heterocyclic compound, which may be condensed to another ring. The heterocyclic group is preferably a 5- or 6-membered heterocyclic group. The hetero atom(s) constituting the heterocyclic group is preferably a nitrogen atom, a sulfur atom, or an oxygen atom. The heterocyclic group is more preferably a 5- or 6-membered aromatic heterocyclic group having 3 to 30 carbon atoms. The hetero ring in the heterocyclic group are exemplified below without denotation of their substitution sites: a pyridine ring, a pyrazine ring, a pyridazine ring, a pyrimidine ring, a triazine ring, a quinoline ring, an isoquinolinev, a quinazoline ring, a cinnoline ring, a phthalazine ring, a quinoxaline ring, a pyrrole ring, an indole ring, a furan ring, a benzofuran ring, a thiophene ring, a benzothiophene ring, a pyrazole ring, an imidazole ring, a benzimidazole ring, a triazole ring, an oxazole ring, a benzoxazole ring, a thiazole ring, a benzothiazole ring, an isothiazole ring, a benzisothiazole ring, a thiadiazole ring, an isoxazole ring, a benzisoxazole ring, a pyrrolidine ring, a piperidine ring, a piperazine ring, an imidazolidine ring and a thiazoline ring.

The alkoxy group represented by R², R³, R⁴, R⁵ and R⁶ includes a substituted or unsubstituted alkoxy group. The substituted or unsubstituted alkoxy group is preferably an alkoxy group having 1 to 30 carbon atoms, e.g. a methoxy group, an ethoxy group, an isopropoxy group, an n-octyloxy group, a methoxyethoxy group, a hydroxyethoxy group, or a 3-carboxypropoxy group.

The aryloxy group represented by R², R³, R⁴, R⁵ and R⁶ is preferably a substituted or unsubstituted aryloxy group having 6 to 30 carbon atoms, e.g. a phenoxy group, a 2-methylphenoxy group, a 4-t-butylphenoxy group, a 3-nitrophenoxy group, or a 2-tetradecanoylaminophenoxy group.

The acyloxy group represented by R², R³, R⁴, R⁵ and R⁶ is preferably a formyloxy group, a substituted or unsubstituted alkylcarbonyloxy group having 2 to 30 carbon atoms, or a substituted or unsubstituted arylcarbonyloxy group having 6 to 30 carbon atoms, e.g. a formyloxy group, an acetyloxy group, a pivaloyloxy group, a stearoyloxy group, a benzoyloxy group, or a p-methoxyphenylcarbonyloxy group.

The carbamoyloxy group represented by R², R³, R⁴, R⁵ and R⁶ is preferably a substituted or unsubstituted carbamoyloxy group having 1 to 30 carbon atoms, e.g. an N,N-dimethylcarbamoyloxy group, an N,N-diethylcarbamoyloxy group, a morpholinocarbonyloxy group, an N,N-di-n-octylaminocarbonyloxy group, or an N-n-octylcarbamoyloxy group.

The alkoxycarbonyloxy group represented by R², R³, R⁴, R⁵ and R⁶ is preferably a substituted or unsubstituted alkoxycarbonyloxy group having 2 to 30 carbon atoms, e.g. a methoxycarbonyloxy group, an ethoxycarbonyloxy group, a t-butoxycarbonyloxy group, or an n-octylcarbonyloxy group.

The aryloxycarbonyloxy group represented by R², R³, R⁴, R⁵ and R⁶ is preferably a substituted or unsubstituted aryloxycarbonyloxy group having 7 to 30 carbon atoms, e.g. a phenoxycarbonyloxy group, a p-methoxyphenoxycarbonyloxy group, or a p-n-hexadecyloxyphenoxycarbonyloxy group.

The amino group represented by R², R³, R⁴, R⁵ and R⁶ includes an alkylamino group, an arylamino group, and a heterocyclic amino group. The amino group is preferably a substituted or unsubstituted alkylamino group having 1 to 30 carbon atoms, or a substituted or unsubstituted arylamino group having 6 to 30 carbon atoms, e.g. an amino group, a methylamino group, a dimethylamino group, an anilino group, an N-methyl-anilino group, a diphenylamino group, a hydroxyethylamino group, a carboxyethylamino group, a sulfoethylamino group, a 3,5-dicarboxyanilino group, or a 4-quinolylamino group.

The acylamino group represented by R², R³, R⁴, R⁵ and R⁶ is preferably a formylamino group, a substituted or unsubstituted alkylcarbonylamino group having I to 30 carbon atoms, or a substituted or unsubstituted arylcarbonylamino group having,6 to 30 carbon atoms, e.g. a formylamino group, an acetylamino group, a pivaloylamino group, a lauroylamino group, a benzoylamino group, or a 3,4,5-trin-octyloxyphenylcarbonylamino group.

The aminocarbonylamino group represented by R², R³, R⁴, R⁵ and R⁶ is preferably a substituted or unsubstituted aminocarbonylamino group having 1 to 30 carbon atoms, e.g. a carbamoylamino group, an N,N-dimethylaminocarbonylamino group, an N,N-diethylaminocarbonylamino group, or a morpholinocarbonylamino group. In the aminocarbonylamino group, the term "amino" has the same meaning as "amino" in the above-described amino group.

The alkoxycarbonylamino group represented by R², R³, R⁴, R⁵ and R⁶ is preferably a substituted or unsubstituted alkoxycarbonylamino group having 2 to 30 carbon atoms, e.g. a methoxycarbonylamino group, an ethoxycarbonylamino group, a t-butoxycarbonylamino group, an n-octadecyloxycarbonylamino group, or an N-methyl-methoxycarbonylamino group.

The aryloxycarbonylamino group represented by R², R³, R⁴, R⁵ and R⁶ is preferably a substituted or unsubstituted aryloxycarbonylamino group having 7 to 30 carbon atoms, e.g. a phenoxycarbonylamino group, a p-chlorophenoxycarbonylamino group, or an m-n-octyloxyphenoxycarbonylamino group.

The sulfamoylamino group represented by R², R³, R⁴, R⁵ and R⁶ is preferably a substituted or unsubstituted sulfamoylamino group having 0 to 30 carbon atoms, e.g. a sulfamoylamino group, an N,N-dimethylaminosulfonylamino group, or an N-n-octylaminosulfonylamino group.

The alkyl- or aryl-sulfonylamino group represented by R², R³, R⁴, R⁵ and R⁶ is preferably a substituted or unsubstituted alkylsulfonylamino group having 1 to 30 carbon atoms, or a substituted or unsubstituted arylsulfonylamino group having 6 to 30 carbon atoms, e.g. a methylsulfonylamino group, a butylsulfonylamino group, a phenylsulfonylamino group, a 2,3,5-trichlorophenylsulfonylamino group, or a p-methylphenylsulfonylamino group.

The alkylthio group represented by R², R³, R⁴, R⁵ and R⁶ is preferably a substituted or unsubstituted alkylthio group having 1 to 30 carbon atoms, e.g. a methylthio group, an ethylthio group, or an n-hexadecylthio group.

The sulfamoyl group represented by R², R³, R⁴, R⁵ and R⁶ is preferably a substituted or unsubstituted sulfamoyl group having 0 to 30 carbon atoms, e.g. an N-ethylsulfamoyl group, an N-(3-dodecyloxypropyl)sulfamoyl group, an N,N-dimethylsulfamoyl group, an N-acetylsulfamoyl group, an N-benzoylsulfamoly group, or an N-(N'-phenylcarbamoyl)sulfamoyl group.

The alkyl- or aryl-sulfinyl group represented by R², R³, R⁴, R⁵ and R⁶ is preferably a substituted or unsubstituted alkylsulfinyl group having 1 to 30 carbon atoms, or a substituted or unsubstituted arylsulfinyl group having 6 to 30 carbon atoms, e.g. a methylsulfinyl group, an ethylsulfinyl group, a phenylsulfinyl group, or a p-methylphenylsulfinyl group.

The alkyl- or aryl-sulfonyl group represented by R², R³, R⁴, R⁵ and R⁶ is preferably a substituted or unsubstituted alkylsulfonyl group having 1 to 30 carbon atoms, or a substituted or unsubstituted arylsulfonyl group having 6 to 30 carbon atoms, e.g. a methylsulfonyl group, an ethylsulfonyl group, a phenylsulfonyl group, or a p-toluenesulfonyl group.

The acyl group represented by R², R³, R⁴, R⁵ and R⁶ is preferably a formyl group, a substituted or unsubstituted alkylcarbonyl group having 2 to 30 carbon atoms, a substituted or unsubstituted arylcarbonyl group having 7 to 30 carbon atoms, or a substituted or unsubstituted heterocyclic carbonyl group having 4 to 30 carbon atoms and being bonded to said carbonyl group through a carbon atom, e.g. an acetyl group, a pivaloyl group, a 2-chloroacetyl group, a stearoyl group, a benzoyl group, a p-n-octyloxyphenylcarbonyl group, a 2-pyridylcarbonyl group, or a 2-furylcarbonyl group.

The alkoxycarbonyl group represented by R², R³, R⁴, R⁵ and R⁶ is preferably a substituted or unsubstituted alkoxycarbonyl group having 2 to 30 carbon atoms, e.g. a methoxycarbonyl group, an ethoxycarbonyl group, a t-butoxycarbonyl group, or an n-octadecyloxycarbonyl group.

The aryloxycarbonyl group represented by R², R³, R⁴, R⁵ and R⁶ is preferably a substituted or unsubstituted aryloxycarbonyl group having 7 to 30 carbon atoms, e.g. a phenoxycarbonyl group, an o-chlorophenoxycarbonyl group, an m-nitrophenoxycarbonyl group, or a p-t-butylphenoxycarbonyl group.

The carbamoyl group represented by R², R³, R⁴, R⁵ and R⁶ is preferably a substituted or unsubstituted carbamoyl group having 1 to 30 carbon atoms, e.g. a carbamoyl group, an N-methylcarbamoyl group, an N,N-dimethylcarbamoyl group, an N,N-di-n-octylcarbamoyl group, or an N-(methylsulfonyl)carbamoyl group.

The aryl- or heterocyclic-azo group represented by R², R³, R⁴, R⁵ and R⁶ includes, for example, a phenylazo group, a 4-methoxyphenylazo group, a 4-pivaloylaminophenylazo group, a 2-hydroxy-4-propanoylphenylazo group.

The imido group represented by R², R³, R⁴, R⁵ and R⁶ includes, for example, an N-succinimido group or an N-phthalimido group.

R¹ is preferably an unsubstituted alkyl group having 1 to 4 carbon atoms, more preferably an unsubstituted alkyl group having I to 3 carbon atoms.

R² is preferably a hydrogen atom, a substituted or unsubstituted alkyl group, a substituted or unsubstituted alkenyl group, or a substituted or unsubstituted aryl group, more preferably a substituted or unsubstituted alkyl group or a substituted or unsubstituted aryl group, further preferably a substituted or unsubstituted alkyl group, particularly preferably a branched alkyl group such as a t-butyl group.

Preferably R³, R⁴, R⁵ and R⁶ each independently represents a hydrogen atom, a halogen atom, a substituted or unsubstituted alkyl group, a substituted or unsubstituted alkenyl group, a substituted or unsubstituted alkoxy group, a substituted or unsubstituted aryloxy group, a substituted or unsubstituted acyloxy group, a substituted or unsubstituted carbamoyloxy group, a substituted or unsubstituted alkoxycarbonyloxy group, a substituted or unsubstituted aryloxycarbonyloxy group, an amino group, a substituted or unsubstituted acylamino group, a substituted or unsubstituted acyl group, or a substituted or unsubstituted alkoxycarbonyl group, more preferably a hydrogen atom, a substituted or unsubstituted alkyl group, a substituted or unsubstituted alkoxy group, or a substituted or unsubstituted acyl group.

The following is an explanation about a preferable combination of various substituents (atoms) that the dye represented by formula (1) may have: A preferred compound is a compound in which at least one of the substituents is the above-described preferable substituent. A more preferred compound is a compound in which many various substituents are the above-described preferable substituents. The most preferred compound is a compound in which all substituents are the above-described preferable substituents. Specific examples of preferable combination include a combination in which R¹ stands for an unsubstituted alkyl group having I to 4 carbon atoms, R² stands for a substituted or unsubstituted alkyl group having I to 6 carbon atoms, R³ stands for a hydrogen atom, and R⁴ , R⁵ and R⁶ each stands for a hydrogen atom; a combination in which R¹ stands for an unsubstituted alkyl group having 1 to 4 carbon atoms, R² stands for a substituted or unsubstituted alkyl group having 1 to 6 carbon atoms, R³ stands for a substituted or unsubstituted alkoxy group having 1 to 6 carbon atoms, and R⁴ , R⁵ and R⁶ each stands for a hydrogen atom; and a combination in which R¹ stands for an unsubstituted alkyl group having 1 to 6 carbon atoms, R² stands for a substituted or unsubstituted alkyl group having 1 to 6 carbon atoms, R³ stands for a substituted or unsubstituted acyl group, and R⁴ , R⁵ and R⁶ each stands for a hydrogen atom.

A molecular weight of the dye represented by formula (1) is preferably 500 or less, and more preferably 400 or less, from a viewpoint of thermal diffusion.

Hereinafter, specific examples of the azo dye represented by formula (I) of the present invention will be shown, but the present invention is not limited thereto.

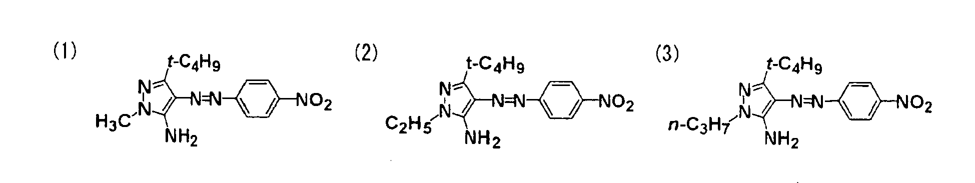

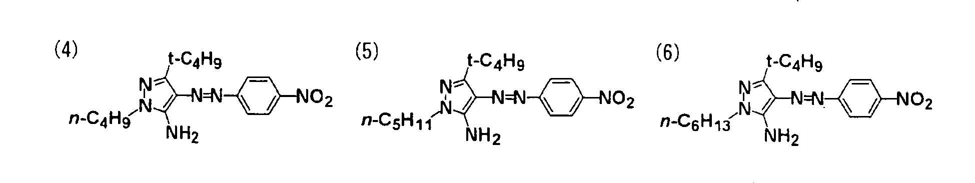

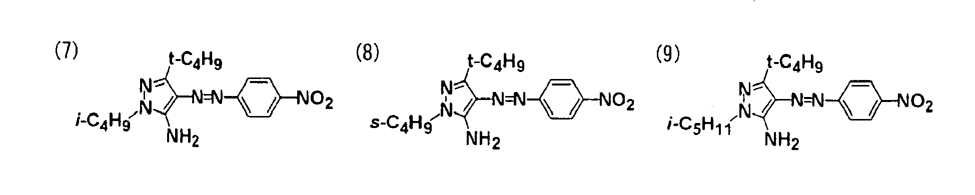

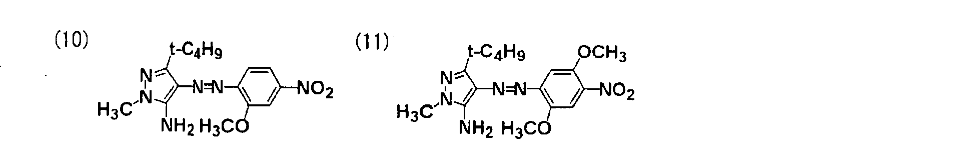

These azo dyes can be synthesized by a diazo coupling method that has been popularly practiced. Specifically, the azo dye can be easily synthesized according to a process in which the amino group of a p-nitroaminophenol derivative is converted to a diazonium salt, followed by a coupling reaction of the diazonium salt and a 2-alkyl-2H-pyrazol-3-ylamine derivative; or a process in which the diazonium salt is coupled with a 2H-pyrazol-3-ylamine derivative having a hydrogen atom at the 2-position of the pyrazol ring, and then the thus-obtained compound is alkylated to introduce an alkyl group onto the nitrogen atom at the 2-position of the pyrazol ring.

More specific synthesis methods are exemplified in the working examples set forth below.

A maximum absorption wavelength of the azo dye of the present invention is preferably 400 to 480 nm, and more preferably 420 to 460 nm.

### (Heat-sensitive transfer recording ink sheet)

The heat-sensitive transfer recording ink sheet of the present invention is characterized in that the above-described azo dye represented by formula (1) is contained in the ink sheet. The heat-sensitive transfer recording ink sheet generally has a structure composed of a support and a dye-providing layer formed on the support. The azo dye represented by formula (1) is contained in the dye-providing layer. The heat-sensitive transfer recording ink sheet of the present invention can be manufactured by the steps of preparing an ink solution by dissolving the azo dye represented by formula (1) in a solvent with a binder or by dispersing the azo dye as fine particles, and forming a dye-providing layer by coating the ink solution on a support, followed by drying, if necessary.

As the support that can be used for the heat-sensitive transfer recording ink sheet of the present invention, use can be made of any support arbitrary selected from conventional supports that have been used for an ink sheet. For example, there can be preferably used such materials as described in paragraph No. 0050 of JP-A-7-137466. A thickness of the support is preferably in the range of from 2 µm to 30 µm.

As a binder resin that can be used for the dye-providing layer in the heat-sensitive transfer recording ink sheet of the present invention, there is no particular limitation of its kind, in so far as the binder has such excellent heat resistance that the binder does not hinder transfer of the dye to an image-receiving layer. Examples of preferable binders include such materials as described in paragraph No. 0049 of JP-A-7-137466. Among these, modified cellulose-based resins and vinyl type resins are preferable; and propionic-acid-modified celluloses, a polyvinylbutyral, and a polyvinyl acetal are more preferable. Similarly, a solvent for forming the dye-providing layer can be arbitrary selected for use from conventionally known solvents. Specifically, such a solvent as used in Example of JP-A-7-137466 can be preferably used.

A content of the azo dye represented by formula (1) in the dye-providing layer is preferably in the range of from 0.03 g/m² to 1.0 g/m², more preferably from 0.1 g/m² to 0.6 g/m². A thickness of the dye-providing layer is preferably in the range of from 0.2 µm to 5 µm, more preferably from 0.4 µm to 2 µm.

The heat-sensitive transfer recording ink sheet of the present invention may have a layer(s) other than the dye-providing layer, within a range not excessively impairing the effect of the invention. For example, there may be an interlayer between the support and the dye-providing layer, or there may be a back layer on the surface of the support (hereinafter, such the surface is sometimes referred to as a "back surface") opposite to the dye-providing layer. Examples of the interlayer include a subbing layer and a diffusion-preventing layer to prevent the diffusion of dyes in the dye-providing layer through the support (a hydrophilic barrier layer). An example of the back layer is a heat resistant slip layer, and by which a thermal head can be prevented from adhesion to the ink sheet.

In order to use the above heat-sensitive transfer recording ink sheet of the present invention as a heat-sensitive recording material capable of recording a full-color image, it is preferred that a cyan ink sheet containing a thermally diffusible cyan dye which can form a cyan image, a magenta ink sheet containing a thermally diffusible magenta dye which can form a magenta image, and a yellow ink sheet containing a thermally diffusible yellow dye which can form a yellow image be formed on a support (base) by applying these sequentially. In addition to the above ink sheets, an ink sheet containing a black-image-forming substance may be further formed as required.

As a cyan ink sheet containing a thermally diffusible cyan dye capable of forming a cyan image, there can be preferably used such ink sheets as described in, for example, JP-A-3-103477 and JP-A-3-150194.

As a magenta ink sheet containing a thermally diffusible magenta dye capable of forming a magenta image, there can be preferably used such ink sheets as described in, for example, JP-A-5-286268.

### (Heat-sensitive transfer recording)

When a heat-sensitive transfer recording is performed using the heat-sensitive transfer recording ink sheet of the present invention, a heating tool such as a thermal head and an image-receiving sheet are used in combination with the heat-sensitive transfer recording ink sheet. Specifically, the image recording is achieved according to a process in which a thermal energy transferred from a thermal head in accordance with image recording signals is given to an ink sheet, and then a dye in the portion to which the thermal energy was given is transferred to an image-receiving sheet and fixed therein. As a composition and a usable material of the image-receiving sheet, such compositions and materials as described in paragraph Nos. 0056 to 0074 of JP-A-7-137466 can be preferably used.

### (Color toner)

The color toner of the present invention is characterized in that the color toner comprises the azo dye represented by formula (I). Any kind of binders which are commonly used, may be used as a color toner binder resin for introducing the dye represented by formula (1) of the present invention. Examples of the binder resin include styrene-based resins, acrylic-based resins, styrene/acrylic resins and polyester resins. Inorganic fine-particles and organic fine-particles may be externally added to the toner, for the purposes of improving fluidity and controlling charge. Silica fine-particles and titania fine-particles whose surfaces are treated, for example, with a coupling agent containing an alkyl group are preferably used. Preferably, these fine-particles have a number average primary particle diameter of 10 to 500 nm and are contained in the toner in an amount of 0.1 to 20 mass%.

Any releasing agents which have been conventionally used for toners may be used in the present invention. Specific examples of the release agent include olefins, such as low-molecular-weight polypropylenes, low-molecular-weight polyethylenes, and ethylene/propylene copolymers; microcrystalline wax, carnauba wax, sazol wax, and paraffin wax. The releasing agent is preferably added to the toner in an amount of 1 to 5 mass%.

The charge-control agent may be added if necessary. It is preferable to use an achromatic charge control agent, from the viewpoint of color-forming property. Examples of the charge control agent include those having a quaternary ammonium salt structure or calyx allene structure.

The carrier to be used may be either an uncoated carrier composed of only magnetic material particles such as iron or ferrite, or a resin-coated carrier obtained by coating the surface of a magnetic material particle with a resin or the like. The average particle diameter of this carrier is preferably 30 to 150 µm in terms of volume average particle diameter.

The method of forming an image, in which the toner according to the present invention is used, is not particularly limited. Examples of the method include a method in which color images are repeatedly formed on a photosensitive material and then transferred, to form an image; and a method in which images formed on a photosensitive material are transferred to an intermediate transfer material and the like sequentially, and then a color image formed on the intermediate transfer material is transferred to an image-forming member such as paper, to form a color image.

### (Ink for inkjet)

The ink for inkjet of the present invention is characterized in that the ink comprises the azo dye represented by formula (1). The ink of the present invention can be prepared by dissolving and/or dispersing the azo dye represented by formula (1), in a lipophilic medium or aqueous medium as the medium. An aqueous medium is preferably used. Because the ink of the present invention contains the dye excellent in fastness to light, heat, an active gas in environment (e.g. oxidative gases such as ozone, NOx, as well as SOx), water, and chemicals, it can be preferably used as an inkjet-recording ink. Other additives may be contained if necessary, within a range not impairing the effect of the present invention. Such other additives include, for example, known additives such as a drying inhibitor (wetting agent), a fade-inhibitor, an emulsion stabilizer, a permeation accelerator, an ultraviolet absorber, an antiseptic, a mildewproofing agent, a pH adjuster, a surface-tension modifier, an antifoaming agent, a viscosity modifier, a dispersing agent, a dispersion stabilizer, a rust preventive, and a chelating agent. These additives are generally added to the dispersion after preparation of the dispersion of the dye, but these additives may also be added to an oil phase or water phase during the preparation.

The above drying inhibitor is preferably used to prevent an inkjet nozzle used in inkjet recording system from being clogged with the dried inkjet recording ink.

The above drying inhibitor is preferably a water-soluble organic solvent having a lower vapor pressure than water. Specific examples of the drying inhibitor include: polyhydric alcohols typified by ethylene glycol, propylene glycol, diethylene glycol, polyethylene glycol, thiodiglycol, dithiodiglycol, 2-methyl-1,3-propanediol, 1,2,6-hexanetriol, acetylene glycol derivatives, glycerin, and trimethylolpropane; lower alkyl ethers of a polyhydric alcohol, such as ethylene glycol monomethyl (or ethyl) ether, diethylene glycol monomethyl (or ethyl) ether, and triethylene glycol monoethyl (or butyl) ether; heterocyclic compounds, such as 2-pyrrolidone, N-methyl-2-pyrrolidone, 1,3-dimethyl-2-imidazolidinone, and N-ethylmorpholine; sulfur-containing compounds, such as sulfolane, dimethyl sulfoxide, and 3-sulfolene; polyfunctional compounds, such as diacetone alcohol, and diethanolamine; and urea derivatives. Out of these, polyhydric alcohols such as glycerin and diethylene glycol are preferred. The above drying inhibitors may be used singly or in combination of two or more of these. The drying inhibitor is preferably contained in the ink in an amount of 10 to 50 mass%.

The above permeation accelerator is preferably used for the purpose of improving permeation of the inkjet ink into paper. As the above permeation accelerator, use can be made of an alcohol, such as ethanol, isopropanol, butanol, di(tri)ethylene glycol monoburyl ether, or 1,2-hexanediol; or a nonionic surfactant, such as sodium laurylsulfate or sodium oleate. In general, the permeation accelerator exhibits a satisfactory effect when it is contained in the ink in an amount of 5 to 30 mass%. The permeation accelerator is preferably used within the range of an amount to be added that does not cause print through or bleeding (blurring) of printed ink or print.

The above ultraviolet absorber is used to improve preservability of an image. Examples of the ultraviolet absorber that can be used include benzotriazole-based compounds disclosed in JP-A-58-185677, JP-A-61-190537, JP-A-2-782, JP-A-5-197075 and JP-A-9-34057, benzophenone-based compounds disclosed in JP-A-46-2784, JP-A-5-194483 and U.S. Patent No. 3214463, cinnamic acid-based compounds disclosed in JP-B-48-30492, JP-B-56-21141 and JP-A-10-88106, triazine-based compounds disclosed in JP-A-4-298503, JP-A-8-53427, JP-A-8-239368, JP-A-10-182621 and JP-T-8-501291 ("JP-T" means searched and published International patent application), compounds disclosed in Research Disclosure No. 24239, and compounds which emit fluorescent light by absorbing ultraviolet radiation, namely so-called fluorescent brighteners typified by stilbene-based or benzoxazole-based compounds.

The above fade-inhibitor is used to improve preservability of an image. As the above fade-inhibitor, use can be made of various kinds of organic or metal complex-based fade-inhibitors. Examples of organic fade-inhibitors include hydroquinones, alkoxyphenols, dialkoxyphenols, phenols, anilines, amines, indanes, chromans, alkoxyanilines, and heterocyclic compounds. Examples of such a metal complex include nickel complexes and zinc complexes. Specific examples of the fade-inhibitor that can be used include compounds disclosed in patents cited in paragraphs 1 to J of Chapter VII of Research Disclosure No. 17643, Research Disclosure No. 15162, left column in page 650 of Research Disclosure No. 18716, page 527 of Research Disclosure No. 36544, page 872 of Research Disclosure No. 307105, and Research Disclosure No. 15162; and compounds included in the formulas of typical compounds and compound examples disclosed in pages 127 to 137 of JP-A-62-215272.

Examples of the mildewproofing agent include sodium dihydroacetate, sodium benzoate, sodium pyridinethion-1-oxide, p-hydroxybenzoic acid ethyl ester, 1,2-benzisothiazolin-3-one, and salts thereof. The mildewproofing agent is preferably used in the ink in an amount of 0.02 to 1.00 mass%.

As the above pH adjuster, use can be made of a neutralizer (organic base or inorganic alkali). The above pH adjuster is preferably added to ensure that the pH of the inkjet ink become preferably 6 to 10, more preferably 7 to 10, for the purpose of improving the shelf stability of the inkjet ink.

As the above surface-tension modifier, mention can be made of a nonionic, cationic or anionic surfactant. The surface tension of the inkjet ink of the present invention is preferably 20 to 60 mN/m, more preferably 25 to 45 mN/m. The viscosity of the inkjet ink of the present invention is preferably 30 mPa.s or less, more preferably 20 mPa·s or less.

Examples of the surfactant include: anionic surfactants, such as fatty acid salts, alkyl sulfuric acid ester salts, alkyl benzene sulfonic acid salts, alkyl naphthalene sulfonic acid salts, dialkyl sulfosuccinic acid salts, alkyl phosphoric acid ester salts, naphthalene sulfonic acid formalin condensates, and polyoxyethylene alkyl sulfuric acid ester salts; and nonionic surfactants, such as polyoxyethylene alkyl ethers, polyoxyethylene alkylallyl ethers, polyoxyethylene fatty acid esters, sorbitan fatty acid esters, polyoxyethylene sorbitan fatty acid esters, polyoxyethylene alkylamines, glycerin fatty acid esters, and oxyethylene oxypropylene block copolymers. SURFYNOLS (trade name, manufactured by Air Products & Chemicals, Inc.) which is an acetylene-based polyoxyethyleneoxide surfactant can also be preferably used. An amine oxide-type amphoteric surfactant, such as N,N-dimethyl-N-alkylamine oxide, is also preferred. Further, surfactants enumerated in pages (37) to (38) of JP-A-59-157636, and Research Disclosure No. 308119 (1989) may also be used.

As the above antifoaming agent, use can be made, if necessary, of a fluorine-containing or silicone-based compound, or a chelating agent typified by EDTA.

in order to disperse the azo dye represented by formula (1) in an aqueous medium, it is preferred that coloring fine-particles containing the compound and an oil-soluble polymer be dispersed in an aqueous medium, as disclosed in JP-A-11-286637, JP-A-2001-240763, JP-A-2001-262039 and JP-A-2001-247788; or that the azo dye represented by formula (1) which is dissolved in a high-boiling organic solvent be dispersed in an aqueous medium, as disclosed in JP-A-2001-262018, JP-A-2001-240763, JP-A-2001-335734 and JP-A-2002-80772. As for the specific method of dispersing the azo dye represented by formula (1) in an aqueous medium, and the oil-soluble polymer, high-boiling organic solvent and additives to be used in the methods, and the amounts to be used thereof, those disclosed by the above patents are preferably adopted. Alternatively, the above bisazo compound in the solid state may be directly dispersed in the form of fine particles. At the time of dispersing, a dispersing agent or a surfactant may be used.

Examples of the dispersing apparatus that can be used include a simple stirrer or impeller, an in-line mixer, a mill (e.g., a colloid mill, a ball mill, a sand mill, an attritor, a roller mill, or an agitator mill), an ultrasonic disperser, and a high-pressure emulsifying disperser (high-pressure homogenizer: gorille homogenizer, micro-fluidizer, DeBEE 2000 (trade name) manufactured by BEE international Co. Ltd., etc. as commercially available apparatuses). In addition to the above patent publications, the details of the methods of preparing the inkjet recording ink are described in JP-A-5-148436, JP-A-5-295312, JP-A-7-97541, JP-A-7-82515, JP-A-7-1 18584, JP-A-11-286637, and JP-A-2001-271003. These methods can also be utilized in the preparation of the inkjet-recording ink of the present invention.

The aqueous medium described above can be a mixture composed of water as a main component and a water-miscible organic solvent as an optional component. Examples of the water-miscible organic solvent include alcohols (e.g., methanol, ethanol, n-propanol, isopropanol, butanol, isobutanol, sec-butanol, t-butanol, pentanol, hexanol, cyclohexanol, and benzylalcohol), polyhydric alcohols (e.g., ethylene glycol, diethylene glycol, triethylene glycol, polyethylene glycol, propylene glycol, dipropylene glycol, polypropylene glycol, butylene glycol, hexanediol, pentanediol, glycerin, hexanetriol, and thiodiglycol), glycol derivatives (e.g., ethylene glycol monomethyl ether, ethylene glycol monoethyl ether, ethylene glycol monobutyl ether, diethylene glycol monomethyl ether, diethylene glycol monobutyl ether, propylene glycol monomethyl ether, propylene glycol monobutyl ether, dipropylene glycol monomethyl ether, triethylene glycol monomethyl ether, ethylene glycol diacetate, ethylene glycol monomethyl ether acetate, triethylene glycol monomethyl ether, triethylene glycol monoethyl ether, and ethylene glycol monophenyl ether), amines (e.g., ethanolamine, diethanolamine, triethanolamine, N-methyldiethanolamine, N-ethyldiethanolamine, morpholine, N-ethylmorpholine, ethylenediamine, diethylenetriamine, triethylenetetramine, polyethyleneimine, and tetramethylpropylenediamine), and other polar solvents (e.g., formamide, N,N-dimethylformamide, N,N-dimethylacetamide, dimethyl sulfoxide, sulfolane, 2-pyrrolidone, N-methyl-2-pyrrolidone, N-vinyl-2-pyrrolidone, 2-oxazolidone, 1,3-dimethyl-2-imidazolidinone, acetonitrile, and acetone). These water-miscible organic solvents may be used in combination of two or more of these.

### (Color filter)

The color filter of the present invention is characterized in that the color filter comprises the azo dye represented by formula (1). As the method of forming a color filter, can be mentioned a method in which a pattern is formed with a photoresist, and then dyed; and a method in which a pattern is formed with a photoresist containing a dye, as disclosed in JP-A-4-163552, JP-A-4-128703 and JP-A-4-175753. To introduce the azo dye represented by formula (1) of the present invention into a color filter, any one of the above methods may be used. Examples of preferred means includes, as disclosed in JP-A-4-175753 and JP-A-6-35182, a positive resist composition containing a thermosetting resin, a quinonediazido compound, a crosslinking agent, a colorant and a solvent; and a method of forming a color filter which comprises: applying the composition onto a base, subjecting the applied base exposure to light through a mask, subjecting the exposed portion to development, to form a positive resist pattern, exposing the entire positive resist pattern to light, and curing the exposed positive resist pattern. Further, a color filter of RGB primary colors or Y. M. C. complementary colors can be obtained, by forming a black matrix in accordance in a usual manner.

As for the thermosetting resin, quinonediazido compound, crosslinking agent and solvent to be used, and the amounts to be used thereof, those disclosed in the above patent publications can be preferably used.

According to the present invention, it is possible to provide a novel azo dye having a high solubility and satisfying excellent spectral characteristics in terms of sharp absorption, high fastness-properties and transferring properties at the same time; a heat-sensitive transfer recording ink sheet containing the azo dye; and a heat-sensitive transfer recording method using the ink sheet. Further, the present invention also provides a color toner, an inkjet ink, and a color filter, each of which contains the azo dye. Therefore, the present invention is expected to be effectively used for a high quality full color recording, and the like. Consequently, a high applicability in the industry is expected.

The present invention provides azo dyes that have a hue preferred in terms of color reproduction, and that are excellent in fastness-properties such as light resistance, humidity resistance, and chemical resistance, and have a high solubility, and that can be preferably used for a color image-recording material and a color filter. Further, the present invention also provides a color toner, an inkjet ink, and a color filter, each using the azo dye.

Further, the present invention provides a heat-sensitive transfer recording ink sheet fulfilling all the requirements of excellent spectral characteristics having a sharp absorption, high fastness properties and excellent transfer sensitivity at the same time, and a heat-sensitive transfer recording method using such the ink sheet.

The azo dyes of the present invention have a hue preferred for color reproduction, and also they are excellent in fastness-properties such as light resistance, humidity resistance, and chemical resistance, and also they have a high solubility, so that they can be preferably used for a color image-recording material and a color filter.

The heat-sensitive transfer recording ink sheet of the present invention not only has high transfer sensitivity, but also has both excellent spectral characteristics in terms of sharp absorption and high fastness-properties, attaining both of which at the same time has been difficult in the current high-speed transfer type heat-sensitive transfer recording. Further, the azo dye of the present invention has an excellent solubility to solvents, which enables to reduce a working load at the time of preparation of an ink sheet and a load to environment. The heat-sensitive transfer recording method using the said ink sheet satisfies all the requirements of excellent color reproduction of a print image, image preservability, and transfer sensitivity.

The color toner containing the azo dye of the present invention has absorption characteristics by which an excellent color reproduction region can be achieved. The color toner of the present invention is also excellent in light resistance.

The inkjet ink containing the azo dye of the present invention has a good yellow hue, a high solubility and an excellent light resistance.

The color filter containing the azo dye of the present invention has a high transmittance and an excellent light resistance and heat resistance.

The present invention will be described in more detail based on the following examples.

The materials, the amounts to be used, the proportions, the details and procedures of treatment or processing, which will be shown in the following working examples, may be appropriately changed or modified, without departing from the spirit of the present invention. Therefore, the following examples are not interpreted as limiting of the scope of the present invention.

### EXAMPLES

### Example I

### Synthesis Example I (Preparation of Exemplified compound (1))

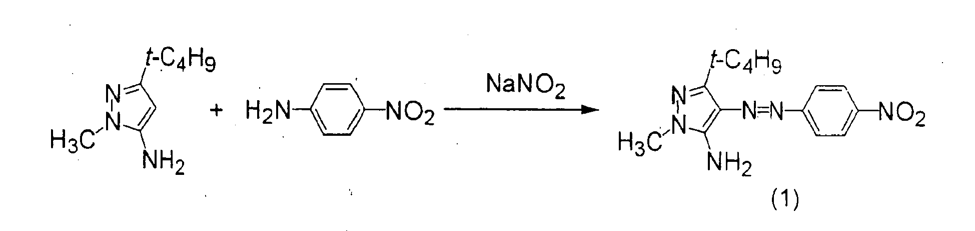

A mixture of 41.4 g of 4-nitroaniline (0.3 mol), 84 ml of conc. hydrochloric acid, 60 ml of acetic acid and 84 ml of propionic acid was stirred at an inner temperature ranging from 0 °C to 5°C. To the mixture was dropped 20.7 g (0.3 mol) of sodium nitrite per 45 ml of water at an inner temperature of 5 °C or less. Thereafter, stirring was continued for 30 minutes at an inner temperature ranging from 0 °C to 5 °C. The resultant diazonium salt solution was dropped to 600 ml of acetonitrile solution containing 46.0 g (0.3 mol) of 5-tert-butyl-2-methyl-2H-pyrazole-3-ylamine at an inner temperature of 10 °C or less. After the dropwise addition of the diazonium salt solution, the resultant reaction solution was kept stirring for 2 hours, followed by injection of 1000 ml of water. Then, the precipitated azo dye was separated by a filtration. Recrystallization of the produced crystals was performed with 1650 ml of methanol, to obtain Exemplified compound (1). Yield: 72 g (80%), Melting point: 199 °C to 201 °C. λmax (ethyl acetate solution) of Exemplified compound (1) was 444 nm.

### Example 2

### Synthesis Example 2 (Preparation of Exemplified compound (2))

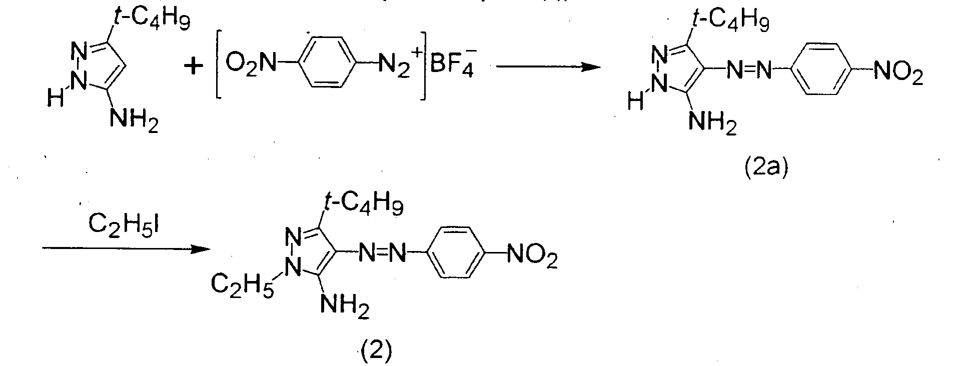

### <Preparation of Intermediate (2a)>

150 ml of acetonitrile solution containing 11.1 g (0.08 mol) of 5-tert-butyl-2H-pyrazole-3-ylamine was cooled to an inner temperature ranging from 0 °C to 5 °C. To the solution was dividedly added 19.0g (0.08 mol) of p-nitrobenzenediazonium fluoroborate. Thereafter, the reaction mixture was stirred for 30 min at an inner temperature ranging from 0 °C to 5 °C and then for 1 hour at room temperature, and then poured into 500 ml of water. After extraction with 200 ml of ethyl acetate, the extracted ethyl acetate phase was washed twice with a saturated aqueous sodium bicarbonate solution and then twice with a saturated brine. The ethyl acetate solution containing a dye was heated up to an inner temperature of 55 °C, followed by addition of 600 ml of hexane. Crystallization was performed, to obtain Intermediate (2a). Yield: 15.7 g (68%)

### <Preparation of Exemplified compound (2)>

A mixture of 2.88 g of Intermediate (2a) (0.01 mol), 1.38 g of potassium carbonate (0.01 mol) and 15 ml of dimethylacetamide was stirred at 0 °C. To the mixture was gradually added dropwise 1.56 g (0.01 mol) of iodo ethane. After stirring for 3 hours at room temperature, 50 ml of water was added thereto. After extraction with 50 ml of ethyl acetate, the extracted solution was washed with saturated brine. Then, the extracted solution was concentrated with a rotary evaporator. Thus-obtained residue was purified using a silica gel chromatography (developing solvent: ethyl acetate/hexane = 1/4, v/v). A yellow powder of Exemplified compound (2) was obtained. Yield: 1.04 g (33%), Melting Point: 150 °C to 152 °C. λmax (ethyl acetate solution) of Exemplified compound (2) was 446 nm.

### Examples 3 to 11

Exemplified compounds (3) to (11) were synthesized in the manners according to the Synthesis Examples I and 2. The maximum absorption wavelength in each of absorption spectra of the thus-obtained Exemplified compounds (3) to (11) in an ethyl acetate solution (density : 1 x 10⁻⁶ mol/L, Optical path length : 10 mm) and the melting point of each of these compounds are shown together with those of the Exemplified compounds (1) and (2) obtained in the Synthesis Examples 1 and 2.

**Table 1**

| Dye | Maximum absorption wavelength (nm) | Melting point (°C) |
|---|---|---|
| (1) | 444 | 199~200 |
| (2) | 446 | 150~152 |
| (3) | 446 | 127~129 |
| (4) | 446 | 124~125 |
| (5) | 446 | 129~131 |
| (6) | 446 | 130~135 |
| (7) | 446 | 120~123 |
| (8) | 446 | 121~129 |
| (9) | 446 | 129~134 |
| (10) | 401 | 218~219 |
| (1 1) | 460 | 224~225 |

### Example 12

### Application Example 1 (Production of heat-sensitive transfer recording ink sheet)

A polyester film of 6.0 µm in thickness (trade name: Lumirror, manufactured by Toray Industries, Inc.), a back surface of which had been subjected to a heat resistant lubricating treatment with a 1 µm thick thermosetting acrylic resin, was used as a support. On the front surface of the film, the following dye-providing layer-coating composition was coated by a wire bar coating so that a dry thinness of the dye-providing layer became 1 µm. Thus, Ink sheet I was prepared.

### (Dye-providing layer-coating composition)

| | |
|---|---|
| Exemplified compound (1) | 5.5 parts by mass |
| Polyvinylbutyral resin | 4.5 parts by mass |
| (Trade name: ESLEC BX-1, manufactured by Sekisui Chemical Co., Ltd.) | |
| Methyl ethyl ketone/toluene (1/1, at mass ratio) | 90 parts by mass |

Ink sheets 2 to 11 and ink sheets for comparison 12 to 14 were produced in the same manner as in the production of the ink sheet 1, except that the above exemplified compound (1) was altered to the following dye as shown in Table 2, respectively.

Solubility of these dyes contained in these ink sheets were evaluated according to the following three grades:
A: the dye easily dissolves.
B: the dye dissolves.
C: the dye is sparingly soluble, but dissolves.

The thus-obtained results are shown in Table 2.

### Example 13

### Application Example 2 (heat-sensitive transfer recording)

### (Production of image-receiving material)

Synthetic paper (trade name: Yupo FPG 200, manufactured by Yupo Corporation, thickness: 200 µm) was used as the support to apply a white-intermediate-layer coating composition and a receptor-layer coating composition having the following compositions in this order to one surface of this support by a bar coater. The application was carried out such that the amount of the white intermediate layer and the amount of the receptor layer after each layer was dried were 1.0 g/m² and 4.0 g/m² respectively, and these layers were respectively dried at 110°C for 30 seconds. White-intermediate-layer coating composition

| | |
|---|---|
| Polyester resin (Trade name: Vylon 200, manufactured by Toyobo Co., Ltd.) | 10 parts by mass |
| Fluorescent whitening agent | I part by mass |
| (Trade name: Uvitex OB, manufactured by Ciba Specialty Chemicals) | |
| Titanium oxide | 30 parts by mass |
| Methyl ethyl ketone/toluene (1/1, at mass ratio) | 90 parts by mass |
| Receptor-layer coating composition | |
| Vinyl chloride/vinyl acetate resin | 100 parts by mass |
| (Trade name: Solbin A, manufactured by Nisshin Chemicals Co., Ltd.) | |
| Amino-modified silicone | 5 parts by mass |
| (Trade name: X22-3050C, manufactured by Shin-Etsu Chemical Co., Ltd.) | |
| Epoxy-modified silicone | 5 parts by mass |
| (Trade name: X22-300E, manufactured by Shin-Etsu Chemical Co., Ltd.) | |
| Methyl ethyl ketone/toluene (= 1/1, at mass ratio) | 400 parts by mass |
| Benzotriazole type ultraviolet absorber | 5 parts by mass |
| (Trade name: Tinuvin 900, manufactured by Ciba Specialty Chemicals) | |

### <Image recording and Evaluation>

The thus-obtained ink sheet 1 and image-receiving material were superposed so that the dye-providing layer in the ink sheet and the image-receiving layer in the image-receiving material were contacted with each other. For printing, a thermal head was used from the back side of the dye-providing material under the following conditions:
Output of the thermal head: 0.25 W/dot; Pulse interval: 0.15 milliseconds to 15 milliseconds; and dot density: 6 dots/mm. Then, the image-receiving layer of the image-receiving material was image-wise colored by the yellow dye. Thereby a brilliant image recording was achieved with no unevenness of transfer printing. Image recordings were conducted in the same manner as the above-described image recording, except that ink sheet I was replaced by ink sheets 2 to 14, respectively.

Status A reflection densities were measured in the portion indicating a solid density (100% dot density) of each of the obtained images, and evaluated according to the following three grades:
A (very good): reflection density of 1.8 or more
B (good): reflection density of 1.6 or more but less than 1.8
C (probably acceptable): reflection density of 1.0 or more but less than 1.6

Next, each of the thus-image-recorded heat-sensitive transfer image-receiving materials was subjected to irradiation with Xenon light (17000 lux) for 7 days, to examine light stability (fastness to light) of the dye image. Status A reflection densities after irradiation were measured in the portions indicating Status A reflection density of 1.0, and a stability of the image was evaluated in terms of a residual ratio (percentage) based on the reflection density before irradiation, according to the following three grades:
A: 80% or more, but 100% or less
B: 60% or more, but less than 80%
C: less than 60%

The thus-obtained results are shown in Table 2.

**Table 2**

| Ink sheet | Dye | Solubility of dye | Transferring property | Light fastness | Remarks |
|---|---|---|---|---|---|
| 1 | (1) | A | A | A | This invention |
| 2 | (2) | A | A | A | This invention |
| 3 | (3) | A | A | A | This invention |
| 4 | (4) | A | A | A | This invention |
| 5 | (5) | A | A | A | This invention |
| 6 | (6) | A | A | A | This invention |
| 7 | (7) | A | B | A | This invention |
| 8 | (8) | A | B | A | This invention |
| 9 | (9) | A | B | A | This invention |
| 10 | (10) | A | A | A | This invention |
| 11 | (11) | A | B | A | This invention |
| 12 | Dye for Comparison 1 | B | B | B | Comparative Example |
| 13 | Dye for Comparison 2 | A | A | C | Comparative Example |
| 14 | Dye for Comparison 3 | B | C | A | Comparative Example |

### Dye for comparison 1

### ( Exemplified compound Y-1 described in JP-A-6-99667)

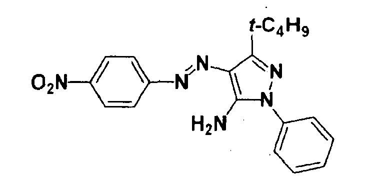

### Dye for comparison 2

### (Chemical formula 24 described in JP-A-2000-313173)

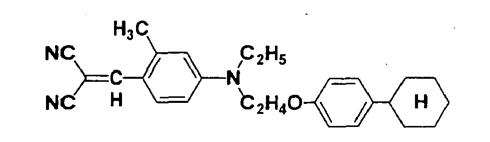

### Dye for comparison 3

### (Chemical formula 21 described in JP-A-2000-313173)

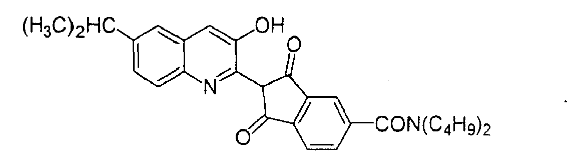

As a result of the above-described image recording tests, it is recognized that the image transferred from the ink sheet containing the azo dye represented by formula (1) to the image-receiving layer had a brilliant hue, and that the dye was excellent in solubility when compared to the ink sheet containing the dye for comparison, and that the dye could sharply reduce a load for dissolution of the dye at the time of preparation of the ink sheet.

It is also understood that each of the azo dyes of the present invention unexpectedly improved in light stability when compared to the dyes for comparison, so that each showed excellent image preservability. It is further understood that transfer sensitivity of the dye of the present invention was also improved. Thus, it is understood that the present invention can solve these problems, image preservability and transfer sensitivity, at the same time, though attaining these properties compatibly has been known to be difficult.

### Example 14

### Application Example 3 (Production of color toner)

3 parts by mass of the azo dye (Exemplified compound (1)) of the present invention and 100 parts by mass of a toner resin (a styrene/acrylate copolymer; trade name: Himer TB-1000F (manufactured by Sanyo Chemical Industries, Ltd.)) were mixed together and ground by a ball mill, and then the resultant mixture was fusion-mixed by heating at 150 °C, cooled, roughly ground by a hammer mill, and then finely ground by an air-jet-type fine grinder. The obtained fine particles were classified to select particles as fine as 1 to 20 µm for use as a toner. Then, 10 parts by mass of the toner and 900 parts by mass of carrier iron powders (trade name: EFV250/400, manufactured by Nippon Teppun Co., Ltd.) were uniformly mixed together, to prepare a developing agent. Reproduction (copying) was carried out by a dry PPC electrophotographic copier (trade name: NP-5000, manufactured by Canon Inc.) using the developing agent. As a result, it is confirmed that the azo dye had excellent spectral characteristics, and it consequently had excellent properties for use as a toner.

### Example 15

### Application Example 4 (Production of ink for inkjet)

5.63 g of the azo dye (Exemplified compound (1)) of the present invention, and 7.04 g of sodium dioctylsulfosuccinate were dissolved in 4.22 g of a high-boiling-point organic solvent (S-2) shown below, 5.63 g of a high-boiling-point organic solvent (S-11) shown below and 50 mL of ethyl acetate at 70 °C. After that, to the resulting solution, was added 500 mL of deionized water, while stirring by means of a magnetic stirrer, to prepare an oil-in-water-type coarse dispersion.

The coarse dispersion thus obtained was passed through a micro-fluidizer (manufactured by MICROFLUIDEX INC.) five times under a pressure of 60 MPa, to obtain an emulsion having finer particles. Then, the resulting emulsion underwent a solvent-removing treatment by means of a rotary evaporator until the smell of ethyl acetate was lost.

In this way, a fine emulsion of a hydrophobic dye was obtained. Then, 140 g of diethylene glycol, 50 g of glycerin, 7 g of SURFYNOL 465 (trade name, manufactured by Air Products & Chemicals Inc.), and 900 mL of deionized water were added to the fine emulsion, to prepare Ink for inkjet.

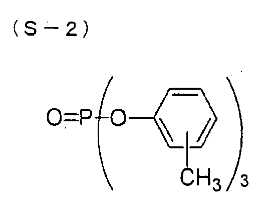

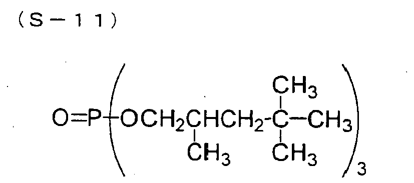

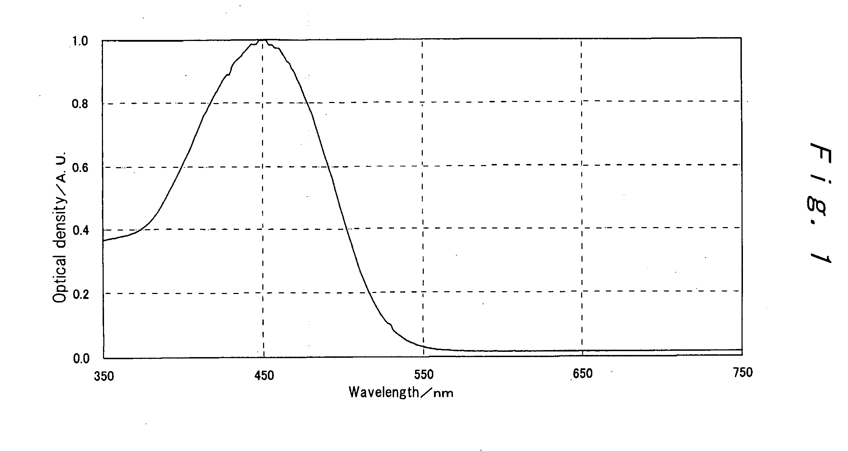

The thus-obtained ink solution was filled in a cartridge of an inkjet printer (PM-G800 (trade name), manufactured by Seiko Epson). Using the printer, an image was recorded on an inkjet paper color photograph finishing PRO (trade name, manufactured by Fuji Film Corporation). A reflection spectrum of the thus-obtained image is shown in Fig. 1. As is apparent from the result of Fig. 1, it is confirmed that the obtained image had excellent spectral characteristics. Thus, it is understood that the inkjet ink had excellent properties.

### Example 16

### Application Example 5 (Production of color filter)

### <Preparation of positive resist composition>

3.4 parts by mass of a cresol novolak resin (mass average molecular weight of 4,300 in terms of polystyrene) obtained from a mixture of m-cresol/p-cresol/formaldehyde (reaction molar ratio = 5/5/7.5), 1.8 parts by mass of o-naphthoquinonediazido-5-sulfonic acid ester (two hydroxyl groups were esterified on average) prepared using a phenol compound represented by the formula below, 0.8 part by mass of hexamethoxymethylolmelamine, 20 parts by mass of ethyl lactate, and 1 part by mass of the azo dye (Exemplified compound (1)) of the present invention were mixed together, to obtain a positive resist composition.

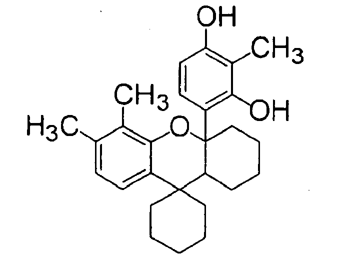

### <Preparation of color filter>

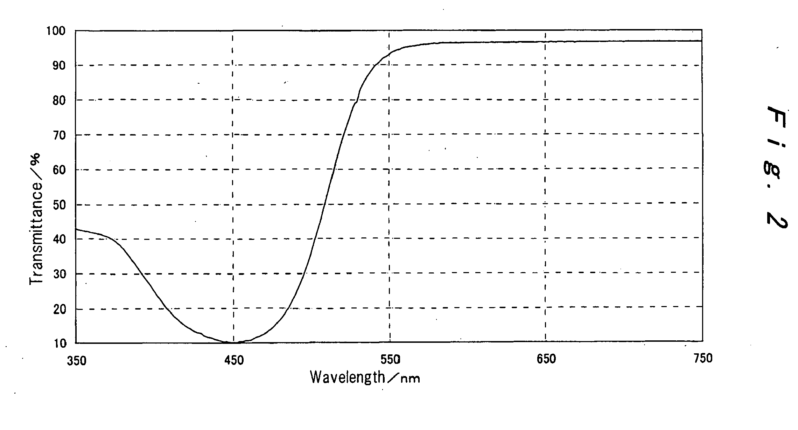

The obtained positive resist composition was coated on a silicon wafer by means of spin coat, followed by evaporation of the solvent. Subsequently, the silicon wafer was exposed to light through a mask, thereby to decompose the quinonediazide compound. Thereafter, the exposed portion was eliminated by heating at 100 °C and subsequently alkali development, thereby to obtain a positive colored pattern having a resolution of 0.8 µm. After subjecting it to a whole-surface exposure and then heating at 150 °C for 15 minutes, was obtained a yellow complementary color type color filter. Exposure was carried out using a i-line exposure stepper HITACHI LD-5010-i (trade name, manufactured by Hitachi Corporation, NA=0.40). As a developing solution, was used SOPD or SOPD-B (each trade name, manufactured by Sumitomo Chemical). A transmission spectrum of the thus-obtained color filter is shown in Fig. 2. As is apparent from the result of Fig. 2, it is confirmed that the obtained color filter had excellent spectral characteristics and light transmittance, thereby providing excellent properties as a color filter.

Having described our invention as related to the present embodiments, it is our intention that the invention not be limited by any of the details of the description, unless otherwise specified, but rather be construed broadly within its spirit and scope as set out in the accompanying claims.

## Claims

1. An azo dye represented by formula (1): 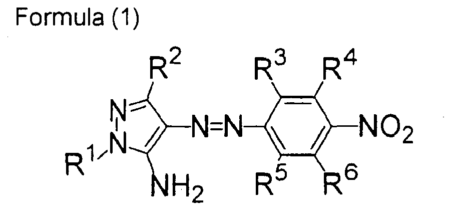 wherein R¹ represents an alkyl group having 1 to 6 carbon atoms; and R², R³, R⁴, R⁵, and R⁶ each independently represents a hydrogen atom or a substituent.

2. The azo dye according to Claim 1, wherein R¹ represents an unsubstituted alkyl group having 1 to 4 carbon atoms; R² represents a substituted or unsubstituted alkyl group having I to 6 carbon atoms; R³ represents a hydrogen atom; and R⁴ , R⁵ and R⁶ each independently represents a hydrogen atom.

3. The azo dye according to Claim 1, wherein R¹ represents an unsubstituted alkyl group having 1 to 4 carbon atoms; R² represents a substituted or unsubstituted alkyl group having 1 to 6 carbon atoms; R³ represents a substituted or unsubstituted alkoxy group having 1 to 6 carbon atoms; and R⁴, R⁵ and R⁶ each independently represents a hydrogen atom.

4. The azo dye according to Claim I, wherein R¹ represents an unsubstituted alkyl group having 1 to 6 carbon atoms; R² represents a substituted or unsubstituted alkyl group having 1 to 6 carbon atoms; R³ represents a substituted or unsubstituted acyl group; and R⁴ , R⁵ and R⁶ each independently represents a hydrogen atom.

5. The azo dye according to Claim 1, wherein R¹ represents an alkyl group having 1 to 6 carbon atoms; and R² represents a t-butyl group.

6. The azo dye according to Claim 1, wherein a molecular weight of the azo dye is 500 or less.

7. The azo dye according to Claim 1, wherein a maximum absorption wavelength of the azo dye is 400 to 480 nm.

8. A heat-sensitive transfer recording ink sheet comprising the azo dye according to Claim 1.

9. The heat-sensitive transfer recording ink sheet according to Claim 8 which comprises a dye-providing layer, wherein a content of the azo dye in the dye-providing layer is in the range of from 0.03 to 1.0 g/m².

10. A heat-sensitive transfer recording method, comprising the step of: forming an image with using the heat-sensitive transfer recording ink sheet according to Claim 8, on an image-receiving material having, on a support (base), an ink-receiving layer containing a polymer.

11. A color toner comprising the azo dye according to Claim 1.

12. An ink for inkjet comprising the azo dye according to Claim 1.

13. A color filter utilizing the azo dye according to Claim 1.
